# EUROPEAN PATENT APPLICATION

(11) **EP 4 815 035 A1**
(43) Date of publication of application: **30.09.2026**
(21) Application number: 25166089.0
(22) Date of filing: 25.03.2025
(51) Int. Cl.: H01L 25/07, H01L 23/36

(54) **POWER SEMICONDUCTOR MODULE AND ASSEMBLY METHOD**

(71) Applicant: Hitachi Energy Ltd, 8050 Zürich (CH)
(72) Inventor: GUILLON, David, 8857 Vorderthal (CH); SANTOLARIY, Lluis, 4600 Olten (CH); BEYER, Harald, 5600 Lenzburg (CH); ROESCH, Andreas, 79730 Murg (DE); FISHER, Noam, 8001 Zürich (CH)
(74) Representative: Michalski Hüttermann & Partner mbB

(57) **Abstract**

The invention relates to a power semiconductor module (1) comprising an electrically conducting base plate (110) and an electrically conducting top plate (120) arranged parallel to each other, a plurality of semiconductor chips (150) arranged on the baes plate (110) facing the top plate, a plurality of electrical contacts (130), each arranged between the top plate (120) and one of the plurality of semiconductor chips (150), electrically connecting the plurality of semiconductor chips (150) in parallel, and a multi-layered structure (140) comprising a stack of electrically conducting elements (141), wherein the plurality of the electrical contacts (130) are interconnected by the multi-layered structure (140), and each element (141) of the multi-layered structure (140) is mechanically and/or electrically connected to at least one of electrical contacts (130).

## Description

### Technical Field

The invention relates to the technical field of power modules, in particular, a power semiconductor module and a method for assembling the power semiconductor module.

### Background Art

Power semiconductor modules are widely used in high-voltage applications like high-voltage direct current, HVDC, systems. These power semiconductor modules, especially power modules with pressure contacts, are typically arranged in a large stack to provide a serial connection of multiple power modules, ensuring efficient power conversion and transmission. Moreover, these modules usually integrate multiple semiconductor devices, such as insulated-gate bipolar transistors, IGBTs, or metal-oxide-semiconductor field-effect transistors, MOSFETs, in a common package, enabling efficient and reliable power switching.

For the modern high-voltage and high-power application utilizing large stack of modules, it is essential to ensure Short Circuit Failure Mode, SCFM, capability. Specifically, in the event of failure, an affected chip must maintain a low-resistance state to sustain uninterrupted current flow, either for an extended period until scheduled maintenance can be conducted or for at least a few minutes until secondary protection mechanisms, such as a mechanical bypass, are activated. In this scenario, the defective module behaves like a simple conductor, whereas the stack of power modules remains functional. Achieving SCFM capability requires the semiconductor module's ability to withstand higher short-circuit current.

Several power semiconductor module designs, especially power modules with pressure contacts, generally incorporate multiple semiconductor chips connected to conductive plates via perpendicularly arranged electrical contacts and faces limitations in current-carrying capability and heat dissipation due to the restricted cross-sectional area of the electrical contacts, particularly in SCFM conditions where the complete short circuit current is carried by a single contact. As power demands increase, existing module designs struggle to support higher operational currents or withstand short-circuit currents exceeding 5,000 A.

One proposed improvement involves integrating a distribution plate to interconnect electrical contacts both electrically and thermally. However, a thick and rigid distribution plate introduces mechanical and thermomechanical stress. Mechanical tolerances, including slight tilts of module components such as chips, metal preforms, or electrical contacts during assembly, as well as mismatch due to different thermal expansion coefficients cannot be effectively compensated, leading to inhomogeneous pressure distribution across the semiconductor chips, and thereby operational reliability and long-term performance of the power semiconductor module with respect to thermal cycling are compromised.

There is thus a need for an improved power semiconductor module with enhanced current-carrying capacity and heat dissipation while minimizing mechanical stress and enhancing long-term durability.

### Summary of invention

It is therefore an object of the invention to provide a long-term reliable power semiconductor module with enhanced current-carrying capacity and heat dissipation, while simultaneously reducing internal mechanical stress and a corresponding assembly method to support the high-current requirements of modern high-voltage, high-power applications.

The object of the invention is solved by the features of the independent claims. Preferred implementations are detailed in the dependent claims.

According to a first aspect of the invention, the object is solved by a power semiconductor module comprising
an electrically conducting base plate and an electrically conducting top plate arranged parallel to each other,
a plurality of semiconductor chips arranged on the base plate facing the top plate,
a plurality of electrical contacts, each arranged between the top plate and one of the plurality of semiconductor chips, electrically connecting the plurality of semiconductor chips in parallel, and
a multi-layered structure comprising a stack of electrically conducting elements.
Wherein the plurality of the electrical contacts are interconnected by the multi-layered structure, and
each element of the multi-layered structure is mechanically and/or electrically connected to at least one of the electrical contacts.

Here, the plurality of electrical contacts may be arranged in one-to-one correspondence with the plurality of semiconductor chips and provide electrical connection between the semiconductor chips and the top plate. The multi-layered structure indicates that the structure comprises two or more layers and is different from one rigid distribution plate with an integrated structure. The number of layers may be determined based on current and/or thermal requirements of the power semiconductor module. In this context, electrically conducting means that the component is electrically conductive.

A key point of the invention is the application of the multi-layered structure to interconnect the plurality of the electrical contacts for current distribution and heat dissipation. On one hand, the multi-layered structure increases an overall cross-section area of the electrical contacts thereby improving both current and thermal distribution. This is particularly advantageous when carrying short-circuit currents, as a significant portion of the current and heat flow is shared by neighbouring contacts. This also facilitates switching balance of the semiconductor module as the temperature homogeneity between individual chips is enhanced. On the other hand, compared with a single rigid distribution plate, the multi-layered structure comprises a stack of electrically conducting elements with reduced rigidity and is less affected by mechanical tolerances in the manufacturing process and thermal expansion during operation, which further improves tolerance compensation across the semiconductor module and enhances its long-term durability.

According to an embodiment of the present invention, each layer of the multi-layered structure comprises at least one electrically conducting element. The non-integrated configuration of the layers further reduces the rigidity of the multi-layered structure, thereby proving better compensation for the mechanical tolerances and thermal expansions during the operation.

In this embodiment, at least one layer of the multi-layered structure may consist of a single electrically conducting element that interconnects all the electrical contacts, while the other layers may comprise multiple electrically conducting elements, each connecting a subset of the electrical contacts. The multiple elements comprised in one layer of the multi-layered structure may be identical or different. Optionally, a layer of the multi-layered structure may only connect a subset or one of the electrical contacts.

The electrically conducting elements may have different shapes and comprise: a full plate interconnecting the plurality of electrical contacts, a partial plate interconnecting a part of the plurality of electrical contacts, a full strip interconnecting all of the plurality of electrical contacts that are arranged in a row or a column, a partial strip interconnecting a subset of the plurality of electrical contacts that are arranged in a row or a column, and/or a washer connected to one of the electrical contacts.

In this embodiment, the plurality of semiconductor chips may be arranged in a matrix with multiple rows and columns on the base plate. Each single electrically conducting element may connect all or a subset of the electrical contacts of the chips. The washers may be arranged on individual electrical contact for height and tolerance compensation.

According to an embodiment of the present invention, the electrically conducting elements are made of a material with high electrical and thermal conductivity. The high electrical and thermal conductivity in this context indicates that the electrical and thermal conductivity of the material is comparable to and not substantially worse than common materials such as copper or aluminium alloys.

Specifically, the material may comprise copper, a copper alloy, aluminium, and/or an aluminium alloy, as well as other materials with similar or superior electrical and thermal conductivity. Additionally, the material may have a melting point higher than a maximum temperature of any part of the power semiconductor module in case of a short-circuit to offer withstand the mechanical and temperature requirement of high-voltage and high-power applications.

According to an embodiment of the present invention, the electrically conducting elements are provided with corresponding through holes and/or recesses for accommodating the plurality of electrical contacts. The through holes and the recesses may be configured to accommodate the electrical contacts for better alignment and easier assembly.

According to an embodiment of the present invention, each of the electrically conducting elements may have a thickness from 0.3 to 10 mm, preferably from 0.3 to 7 mm, most preferably from 0.3 to 1.5 mm. The thickness of each electrically conducting element may be the same or different and is determined based on the practical current and/or heat dissipation requirements of the power semiconductor module. In some preferred embodiments of the present invention, all conducting elements included in one layer may have the same thickness. Alternatively, the conducting elements included in one layer may also have different thickness.

In cases of high current and/or heat dissipation requirements, the number of layers in the multi-layered structure may be increased to enhance its overall thickness. This configuration utilizes multiple thin layers to improve the current-carrying and heat dissipation capabilities of the power semiconductor module while compensating for mechanical tolerances, thereby enhancing the performance of the module.

In one embodiment of the present invention, the plurality of electrical contacts may comprise pressure contacts and/or columnar contacts.

In an optional embodiment, the power semiconductor module may comprise a plurality of metal preforms. Each metal preform is arranged between one of the plurality of electrical contacts and the plurality of semiconductor chips.

Here, metal preform refers to a metal layer or electrode. The metal preforms may be formed on a top contact surface of each semiconductor chip. Typically, the metal preforms can be made of molybdenum or aluminium.

According to this embodiment, in the event of failure, the high temperature of the affected chip and electrical contact causes the corresponding metal preform to melt, forming a eutectic alloy that renders the affected chip conductive as a short circuit, thus enhancing the SCFM capability of the module. In addition, the metal preform may arranged for compensation of mismatches between the chips and the electrical contacts or other components due to different coefficients of thermal expansion.

According to one embodiment of the present invention, each of the plurality of electrical contacts comprises a presspin body and an elastic element arranged on the presspin body. Specifically, each presspin body comprises a pin foot oriented toward one of the plurality of semiconductor chips. Optionally, the elastic element may comprise a spring and/or an electrically conducting bracket surrounding the spring. Optionally, the elastic element may be sleeved on the presspin body.

In this embodiment, the electrical contact may be a pressure contact with the press pin body and the elastic element. The force applied to the elastic element presses the pin foot against the semiconductor chip. Pressure contacts offer a solder-free, reusable, and mechanically stable connection with reliable conductivity, easy assembly, and compatibility with automated manufacturing while minimizing thermal damage and enhancing durability.

In this embodiment, the multi-layered structure may be sleeved on the presspin bodies between the elastic elements and the pin feet of the presspin bodies. Each electrically conducting element comprised in the multi-layered structure may have corresponding through holes to accommodate the presspin bodies.

In one specific embodiment, the foot of each presspin body may have a diameter and/or width greater than that of an upper portion of the presspin body and define a stepped surface facing the top plate. The multi-layered structure may be sleeved on the upper portions of the presspin bodies and arranged between the elastic elements and the stepped surfaces.

With this configuration, the multi-layered structure can be secured between the elastic elements and the stepped surface, which facilitates the mechanical reliability of the semiconductor module and ensures homogeneous mechanical force distribution across all semiconductor chips.

According to an embodiment of the present invention, the elastic element may comprise a spring and an electrically conducting bracket surrounding the spring, and the multi-layered structure can be sleeved on the presspin bodies between the brackets and the pin feet of the presspin bodies.

In this design, the spring may maintain a consistent contact pressure during all operation modes of the power semiconductor module, while the electrically conducting brackets provides a low-resistance path between the electrical contacts and the multi-layered structure or between the top plate and the multi-layered structure for current carrying. This design in thus suitable for high-voltage and high-power applications that require enhanced operational reliability and durability.

Alternatively, the multi-layered structure may be arranged between the plurality of electrical contacts and the plurality of semiconductor chips.

By positioning the multi-layered structure between the electrical contacts and the semiconductor chips, direct current distribution and improved heat dissipation are provided closer to the chip level, which minimizes electrical resistance, ensuring a more efficient and uniform current flow. Specifically, in SCFM case, a shorter current path between the multi-layered structure and the affected chip can be established which in turn enhances the SCFM capability from thermal and electrical point of view.

According to this alternative embodiment of the invention, when metal preforms are applied, each metal preform may be arranged on a contact surface of one of the plurality of semiconductor chips facing the top plate. The multi-layered structure can be arranged between the plurality of electrical contacts and the plurality of metal preforms. In this embodiment, the metal preforms are in direct contact with the semiconductor chip while the electrical contacts are in direct contact with the multi-layered structure.

Alternatively, the foot of each electrical contact abuts one of the plurality of metal preforms, and the multi-layered structure may be arranged between the plurality of metal preforms and the plurality of semiconductor chips. In this design, the multi-layered structure is placed in direct contact with the semiconductor chips to further enhance heat dissipation and current distribution while preventing localized overheating.

Another aspect of the invention further provides a method for assembling the power semiconductor module according to any one of the previous claims, comprising the steps of:
attaching the plurality of semiconductor chips to the electrically conducting base plate,
interconnecting the plurality of electrical contacts with the multi-layered structure,
attaching the electrically conducting top plate to the plurality of electrical contacts, and
aligning and attaching the plurality of electrical contacts to the plurality of semiconductor chips.

The semiconductor chips can be attached to the base plate via soldering, sintering or other similar approaches.

Optionally, the method may further comprise the step of attaching the plurality of metal preforms to the plurality of semiconductor chips. The metal preforms may be connected to the plurality of semiconductor chips via soldering, sintering or adhesive bonding.

In some embodiments, when the multi-layered structure is positioned between the plurality of electrical contacts and the plurality of semiconductor chips, the step of interconnecting and attaching the plurality of electrical contacts may respectively further comprise the steps of attaching the multi-layered structure to the plurality of semiconductor chips or the plurality of metal preforms, and aligning the plurality of electrical contacts with the plurality of semiconductor chips and connecting the plurality of electrical contacts to the multi-layered structure.

When the plurality of electrical contacts are pressure contacts, the method may further comprise pressing the top plate towards a direction to the plurality of semiconductor chips.

### Brief description of drawings

These and other aspects of the invention will be apparent from and elucidated with reference to the implementations described hereinafter.

In the drawings:
Fig. 1 shows a side view diagram of an embodiment of a power semiconductor module with a multi-layered structure.
Fig. 2 shows a side view diagram of another embodiment of a power semiconductor module with a multi-layered structure and metal preforms.
Fig. 3 shows a top view diagram of an electrically conducting element of the multi-layered structure according to an embodiment of the present invention.
Fig. 4 shows a top view diagram of another electrically conducting element of the multi-layered structure according to an embodiment of the present invention.
Fig. 5 shows a top view diagram of another electrically conducting element of the multi-layered structure according to an embodiment of the present invention.
Fig. 6 shows a top view diagram of another electrically conducting element of the multi-layered structure according to an embodiment of the present invention.
Fig. 7 shows a top view diagram of another electrically conducting element of the multi-layered structure according to an embodiment of the present invention.
Fig. 8 shows a top view diagram of another electrically conducting element of the multi-layered structure according to an embodiment of the present invention.
Fig. 9 shows a side view diagram of an embodiment of a power semiconductor module with a multi-layered structure and pressure contacts.
Fig. 10 shows a side view diagram of another embodiment of a power semiconductor module with a multi-layered structure, pressure contacts and metal preforms.
Fig. 11 shows a side view diagram of another embodiment of a power semiconductor module with a multi-layered structure arranged between electrical contacts and metal preforms.
Fig. 12 shows a side view diagram of another embodiment of a power semiconductor module with a multi-layered structure arranged between metal preforms and semiconductor chips.
Fig. 13 shows a flow chart according to an embodiment of a power semiconductor module assembling method.

### Description of implementations

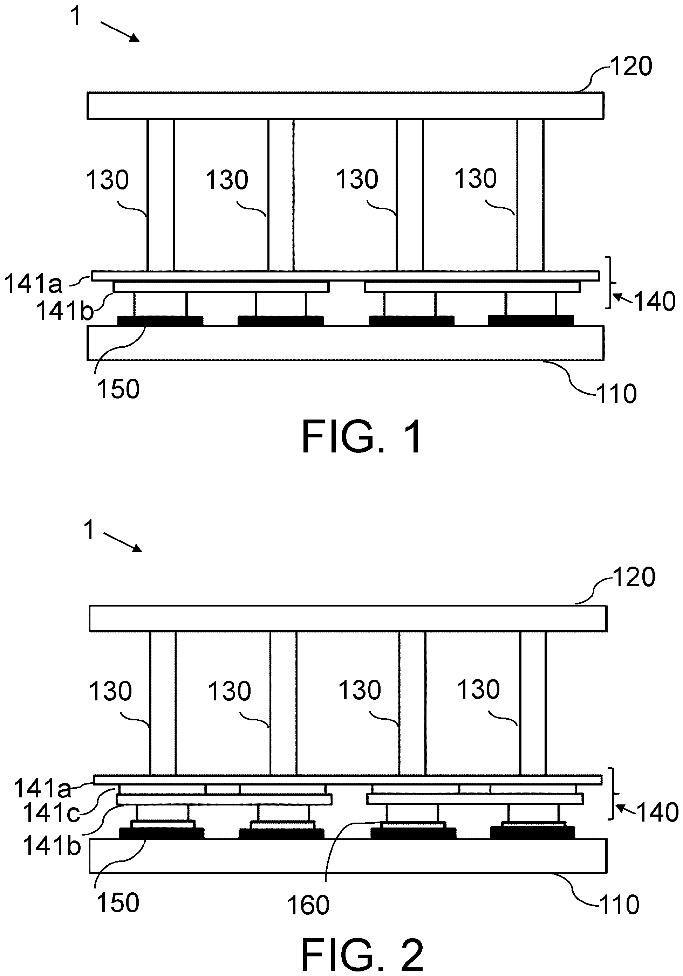

Fig. 1 shows a side view diagram of a power semiconductor module 1 with a multi-layered structure 140 for current distribution and/or heat dissipation according to an embodiment of the present invention.

As shown in Fig. 1, the power semiconductor module 1 comprises an electrically conducting base plate 110 and an electrically conducting top plate 120 arranged in parallel to each other. A plurality of semiconductor chips 150 is arranged on the base plate 110 facing the top plate 120 with a plurality of electrical contacts 130 electrically connecting the plurality of semiconductor chips 150 in parallel. Specifically, each electrical contact 130 is arranged between the top plate 120 and one semiconductor chip 150. The power semiconductor module 1 further comprises a multi-layered structure 140 mechanically and electrically connected to the plurality of electrical contacts 130. The multi-layered structure 140 may comprise one layer of an electrically conducting element 141a interconnecting all the electrical contacts 130 and another layer consisting of two electrically conducting elements 141b that each connects only part of the electrical contacts 130.

Here, the semiconductor power module 1 refers to a functional unit of power applications. It can be combined with other semiconductor power modules, capacitors, and /or control circuitry, into a single package to handle power conversion, regulation, or switching at a system level. For different definition, the semiconductor power module may also refer to semiconductor power submodule, such as a semiconductor switching unit.

Although not depicted in Fig. 1, the semiconductor power module 1 may comprise multiple rows and columns of electrical contacts 130. The electrical contacts may be arranged in a manner forming a kind of array or 2D arrangements. The number of rows and columns may be determined based on the practical requirements of the power applications.

The semiconductor chips may be bipolar-type or a MOSFET-type switches. The semiconductor chips may comprise an Insulated Gate Bipolar Transistor, IGBT, a Gate Turn-Off Thyristor, GTO, an Integrated Gate-Commutated Thyristor, IGCT, High Electron Mobility Transistor, HEMT, and/or other similar devices.

Optionally, each layer of the multi-layered structure 140 may include at least one electrically conducting element 141. Moreover, the number of layers can vary and may be determined based on the practical requirements of the application. The lateral dimension, i.e., width and length of the multi-layered structure 140 may be defined by geometric boundary conditions of the power semiconductor module 1. The lateral dimension may also be defined with respect to the arrangement of the electrical contacts 130. The layers of the multi-layered structure 140 may be provided as sperate components.

Fig. 2 illustrates a side view diagram of a power semiconductor module 1 with a multi-layered structure 140 for current distribution and/or heat dissipation according to another embodiment of the present invention. Unlike the embodiment shown in Fig. 1, the multi-layered structure depicted in Fig. 2 may comprise three layers. **In** addition to a first layer consisting of a single electrically conducting element 141a interconnecting all electrical contacts 130 and a second layer consisting of two electrically conducting elements 141b, each connecting only a portion of the electrical contacts, the multi-layered structure 140 shown in Fig. 2 further includes a third layer consisting of electrically conducting elements 141 that connect to only one electrical contact 130.The third layer is arranged between the first and the second layers. **In** some embodiments, the number of electrically conducting elements 141c in the third layer may be fewer than the number of electrical contacts 130.

Specifically, the electrically conducting elements 141 may be made of a material with high electrical and thermal conductivities. For example, the electrically conducting elements may be made of copper, copper alloy, aluminium, aluminium alloy and/or other material with similar or better electrical and thermal conductivities. In some specific embodiments, the electrical conductivity of the material may be higher than 15 MS/m, preferably, higher than 25 MS/m. The thermal conductivity of the material may higher than 120 W/m·K, preferably, higher than 200 W/m·K. In addition, the material may have a melting point higher than the maximum temperature of the power semiconductor in the event of short-circuit failures.

In this embodiment, an individual electrically conducting element 141 may be made entirely of a material having high electrical and thermal conductivity, or at least a portion of the electrically conducting element 141 may be formed of such a material. Optionally, an individual electrical contact 130 may be made entirely or partly of the material having high electrical and thermal conductivity.

In some embodiments of the present invention, the multi-layered structure 140 may comprise through holes and/or recesses to accommodate or to be arranged on the plurality of electrical contacts 130. Optionally, the multi-layered structure 140 may comprise aligning structures for better alignment with the electrical contacts 130.

Specifically, the electrically conducting elements 141 may include corresponding through holes and/or recesses to accommodate or to be arranged on the plurality of electrical contacts 130, ensuring better alignment and easier assembly. The dimensions of the through holes and recesses may be defined based on the dimension of single electrical contact 130. For example, when the electrical contacts have a round cross-sectional shape, a diameter of the through hole or recesses may be equal to or slightly larger than a diameter of the electrical contacts so that the multi-layered structure 140 can be smoothly and securely attached to the electrical contacts 130, allowing a certain mechanical tolerance. Additionally, the number of corresponding through holes and/or recesses may be determined by the number of electrical contacts 130 interconnected by the electrically conducting element 141.

Alternatively, the electrically conducting elements 141 may not comprises through holes or recesses and the plurality of electrical contacts 130 may be interconnected via surface contacts to the multi-layered structure 140 formed by the stack of electrically conducting elements 141. As a specific example, the multi-layered structure 140 may comprises aligning structures, such as aligning holes for improved arrangement, for alignment of elements of the multi-layered structure with respect to each other.

In some specific examples, the multi-layered structure 140 may comprise only electrically conducting elements 141 with through holes and/or recesses or the multi-layered structure 140 may comprise only electrically conducting elements 141 without through holes or recesses. As an alternative, the multi-layered structure 140 may comprises electrically conducting elements 141 with through holes and/or recesses, as well as electrically conducting elements 141 without through holes or recesses. Optionally, the electrically conducting elements 141 with through holes and/or recesses may be arranged as outer surfaces of the multi-layered structure 140 for alignment with the electrical contacts 130 or other components. For example, the multi-layered structure 140 may comprise a bottom layer without through hole or recess contacting with the semiconductor chips and an upper layer with through holes or recess. The electrical contacts may then be aligned and arranged in the through hole or recess. Preferably, the through holes and the recesses may also provide alignment or certain clamping between the electrically conducting elements 141 for fixture.

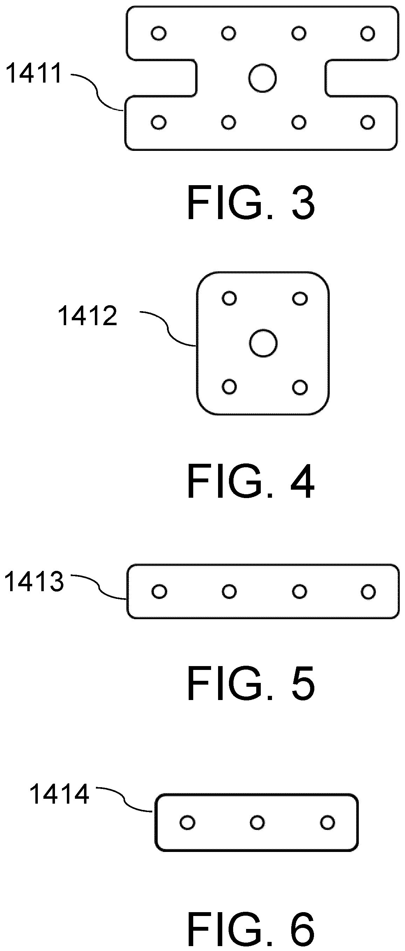

Fig. 3 to Fig. 8 present different examples of electrically conducting elements 141 forming the multi-layered structure 140.

As shown in Fig. 3, the electrically conducting element 141 may be a full plate 1411 interconnecting the plurality of electrical contacts 130. The full plate 1411 depicted in Fig. 3 is designed for the power semiconductor module 1 with a 2 × 4 semiconductor chip configuration and thus comprise 8 through holes/recesses to accommodate or to be arranged on the corresponding electrical contacts. The number and configuration of semiconductor chips may vary. In some specific examples, the full plate 1411 may include n × m through holes and/or recesses, where n and m are any integers greater than 1. In other specific examples, the semiconductor chips 150 may be arranged in an arbitrary manner, i.e., not forming an array, the arrangement of the through-holes and/or recesses may be defined by an arrangements of the plurality of semiconductor chips 150.

Moreover, as depicted in Fig. 3, the full plate may contain lightening holes and/or other lightening structures to further reduce the weight and rigidity of the full plate 1411. Moreover, the full plate 1411 may comprise an avoidance structure to provide space for other contacts arranged mechanically in parallel with the electrical contacts 130. The other contacts are not electrically connected in parallel with the electrical contacts 130. For example, when the plurality of the electrical contacts 130 provide electrical connections to the emitters of the plurality of chips 150, the other contacts may provide electrical connections to the gates of the plurality of chips 150. The lightening holes and/or the lightening structures may function as the avoidance structure. As an option, a thickness of the full plate 1411 may be uniform or non-uniform. For instance, the full plate may comprise locally thinned or narrowed portions for stress relief.

Fig. 4 illustrates a partial plate 1412 that interconnects a subset of the plurality of electrical contacts 130. The partial plate 1412 depicted in Fig. 4 features 2 × 2 through holes or recesses to interconnect four electrical contacts 130. In practice, the number and arrangement of through holes or recesses may vary depending on the number and layout of the electrical contacts 130 to be interconnected. Similarly to the full plate 1411, the partial plate 1412 may also include lightening holes and/or other lightening structures to further reduce its weight and rigidity. The partial plate 1412 may also comprise the avoidance structure. The lightening holes and/or the lightening structures may also function as the avoidance structure. Moreover, a thickness of the partial plate 1412 may be uniform or non-uniform. That is, the partial plate may comprise locally thinned or narrowed portions for stress relief.

Fig. 5 presents a full strip 1413 that interconnects all electrical contacts 130 arranged in a row or in a column. The full strip 1413 shown in Fig. 5 is designed for a power semiconductor module 1 with an n × 4 semiconductor chip configuration and, accordingly, includes four through holes or recesses. In this embodiment, the multi-layered structure 140 may comprise a layer consisting of n full strips connecting the n rows of electrical contacts 130. In other examples, each row of the semiconductor module 1 may contain a different number of semiconductor chips 150, and the number of through holes or recesses in the full strip 1413 may vary accordingly. As an option, the full strip 1413 may be used to interconnect all electrical contacts 130 arranged along a diagonal.

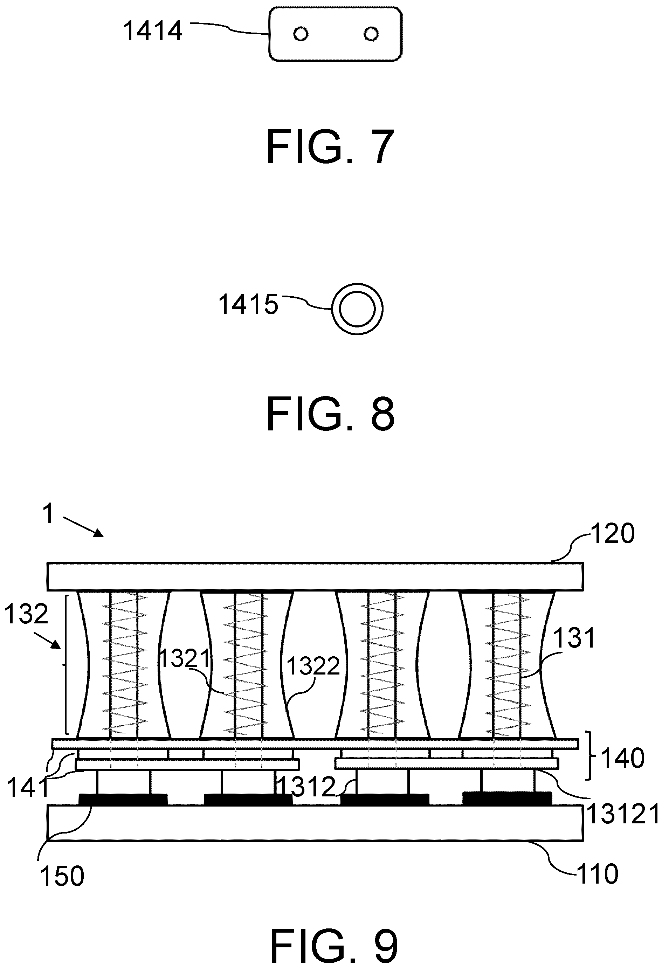

Figs. 6 and 7 illustrate partial strips 1414 that interconnect a subset of the electrical contacts 130 arranged in a row. The number of corresponding through holes or recesses in the partial strips is determined based on the number of electrical contacts 130 to be connected. For example, the partial strip 1414 depicted in Fig. 6 is designed to interconnect three electrical contacts 130, while the partial strip 1414 shown in Fig. 7 is designed to interconnect only two electrical contacts. Additionally, the partial strips 1414 may also be configured to connect electrical contacts 130 arranged in a column or along a diagonal.

Fig. 8 illustrates an electrically conducting element 141 that connects only one electrical contact 130, which may be a washer 1415. The washer can be used for height adjustment and compensation within the multi-layered structure 140. It is not necessary to apply washers to every electrical contact 130. In some specific embodiments, the multi-layered structure 140 may include a layer comprising at least one washer 1415 connected to at least one electrical contact 130 for height compensation. In this example, the layer may not have a homogeneous thickness. Alternatively, the multi-layered structure 140 may include a layer consisting of multiple washers 1415 connected to multiple electrical contacts 130 to further reduce the rigidity of the multi-layered structure 140. As another option, the multi-layered structure 140 may include a layer consisting of multiple washers 1415 and partial strips 1414 and/or partial plates 1412. All combinations are possible.

The multi-layered structure 140 may comprise a stack of any combination of the above-described electrically conducting elements 141. For instance, in the example illustrated in Fig. 1, the multi-layered structure 140 comprises a layer of the full plate 1411 and a layer of partial strips 1414.In another example illustrated in Fig. 2, the multi-layered structure 140 comprises a layer of the full plate 1411, a layer of washers 1415 and a layer of partial strips 1414. Other combinations are also possible.

Optionally, the thickness of the electrically conducting elements may vary within a range of 0.3 to 10 mm, preferably 0.3 to 7 mm, and most preferably 0.3 to 1.5 mm. The thickness of electrically conducting elements comprised in different layers may be uniform or different and is determined based on the practical current-carrying and/or heat dissipation requirements of the power semiconductor module. For instance, when the power semiconductor module 1 requires a multi-layered structure 140 with a thickness of 3mm. The multi-layered structure 140 may comprise a layer of 1mm thick full plate 1411, a layer of 1 mm thick full strips 1413 and a layer of 1mm thick partial strips 1414. Alternatively, the multi-layered structure 140 may comprises a layer of a 1 mm thick full plate 1411, a layer of a 0.5 mm thick full strips 1413 and a layer of a 1.5 mm thick partial strips 1414. The specific configuration may be determined based on the requirements of the applications.

As further depicted in Fig. 2, the power semiconductor module 1 may comprise a plurality of metal preforms 160. Each metal preform is arranged between one of the plurality of electrical contacts 130 and the plurality of semiconductor chips 150. As discussed above, in the event of a short circuit failure, the metal preforms melt and form a eutectic alloys that renders the affected chips conductive in a short circuit, thus enhancing the SCFM capability of the module. Additionally, the metal preforms 160 may be used to compensate mechanical stress due to mismatch in thermal expansion of electrical contacts 130 and the semiconductor chips 150. The metal preforms 160 may be arranged or displaced on the top contact surfaces of the plurality of semiconductor chips 150 and are typically made of molybdenum or aluminium.

The electrical contacts 130 depicted in Fig. 1 and Fig. 2 are columnar contacts. However, the electrical contacts can also be pressure contacts or spring contacts.

Fig. 9 presents a side view diagram of another embodiment of the power semiconductor module 1 featuring the multi-layered structure 140 and pressure contacts. As shown in Fig. 9, each electrical contact 130 may include a presspin body 131 and an elastic element 132. The elastic element 132 may be arranged on or sleeved onto the presspin body 131. Additionally, the presspin body 131 may include a pin foot 1312 extending toward the corresponding semiconductor chip 150 connected to the electrical contact 130. When force is applied to the elastic element 132, it presses the pin foot 1312 against the corresponding semiconductor chip 150, enabling a pressed connection. The pin foot 1312 may be an integrated part of the press pin body, or the pressspin body 131 may comprises a pin that flexibly connected to its pin foot 1312. Although not depicted in the figures, other setups of pressure contacts are also possible.

The multi-layered structure 140 may also be sleeved onto the presspin bodies 131 of the plurality of electrical contacts 130 and positioned between the elastic elements 132 and the pin feet 1312 for current distribution, as well as heat spreading and dissipation.

Optionally, Fig. 9 also depicts that the pin foot 1312 of each presspin body 131 may have a diameter or width larger than that of the upper portion of the presspin body, thereby forming a stepped surface 13121 facing the direction of the top plate. The stepped surface 13121 may constitute a top surface of the pin foot 1312. In this embodiment, the multi-layered structure 140 may be pressed between the elastic elements 132 and the stepped surfaces 13121 of the pin feet 1312. In addition to providing enhanced mechanical stability, the stepped surfaces 13121 increase the contact area between the multi-layered structure 140 and the plurality of electrical contacts 130, thereby facilitating a more balanced distribution of current. In addition, when the multi-layered structure 140 is placed between the elastic elements 132 and the pin feet 1312, it may provide exposal of pressure on the pin feet.

As further shown in Fig. 9, each elastic element 132 may comprise a spring 1321 and an electrically conducting bracket 1322 surrounding the spring 1321. The spring 1321 may function to maintain a consistent contact pressure during all operation modes of the power semiconductor module, while the electrically conducting brackets 1322 may function to carry the current flowing to the semiconductor chips 150. The multi-layered structure 140 may be sleeved on the presspin body 131 and be arranged between the electrically conducting brackets 1322 and the stepped surfaces 13121 of the pin feet 1312.

Although not depicted in the figures, each elastic element 132 may only comprises an electrically conducting bracket 1322 arranged above or sleeved on the presspin body 131. Alternatively, although not depicted in the figures, the elastic element 132 may be arranged above the presspin bodies 131 while the multi-layered structure 140 may be attached between the elastic elements 132 and the presspin bodies 131. The multi-layered structure may connect to the elastic elements 132 and the presspin bodies 131 by surface contact.

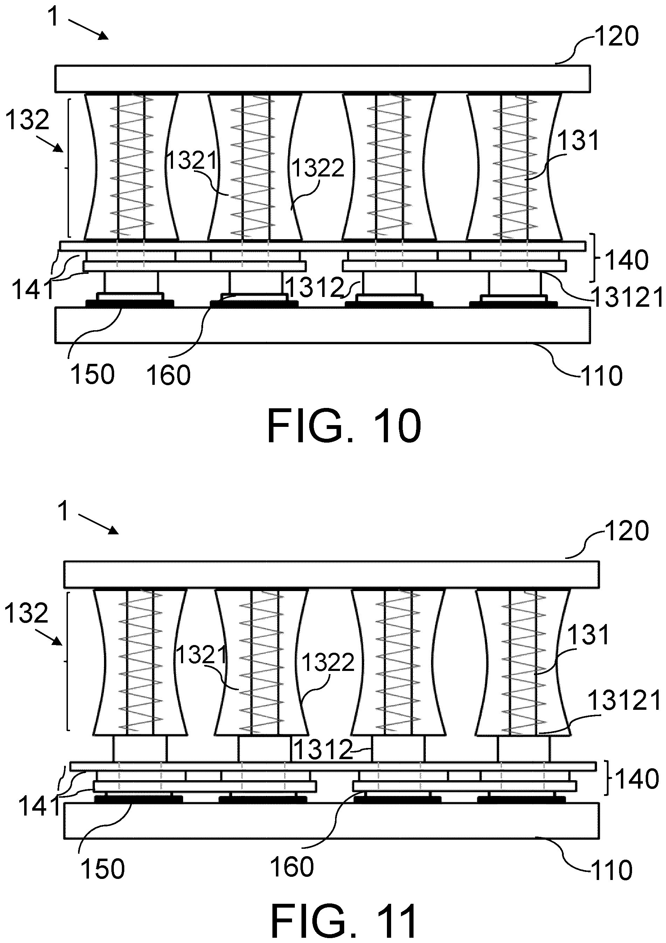

Fig. 10 presents a side view diagram of another embodiment of a power semiconductor module 1 featuring the multi-layered structure 140 and pressure contacts. Unlike the embodiment shown in Fig. 9, this embodiment further includes metal preforms 160 arranged on the contact surfaces of the plurality of semiconductor chips 150. The pin feet 1312 of the electrical contacts 130 may contact the metal preforms 160 directly, with the multi-layered structure 140 positioned between the elastic elements 132 and the pin feet 1312.

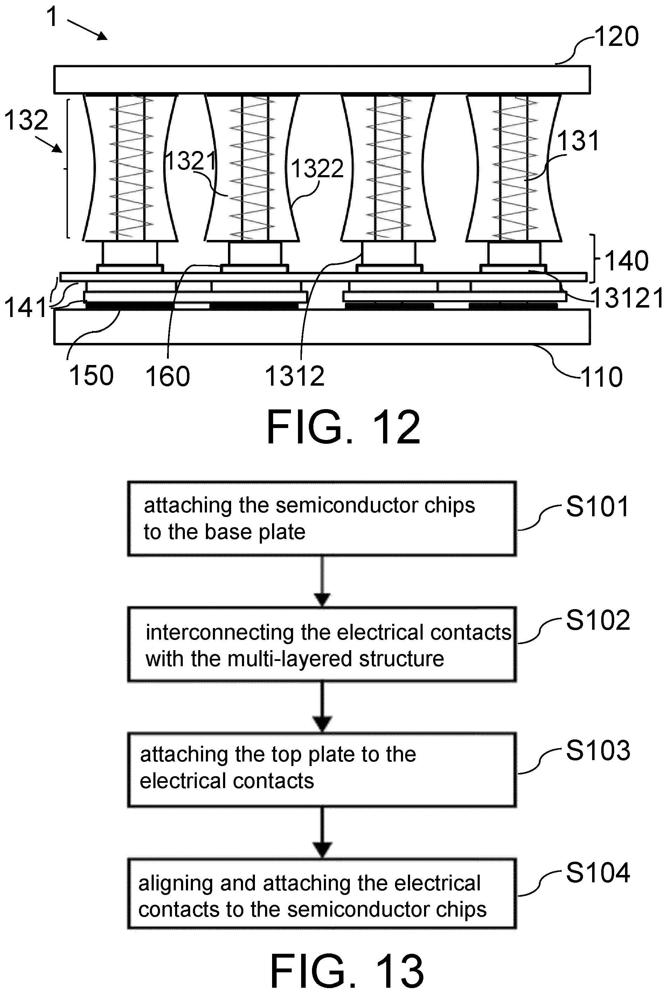

To facilitate current distribution and heat dissipation at the chip level, the multi-layered structure 140 may be arranged between the plurality of electrical contacts 130 and the plurality of semiconductor chips 150 as shown in Fig. 11 and Fig. 12.

Fig. 11 and Fig. 12 illustrate side view diagrams of two embodiments of the power semiconductor module 1 in which the multi-layered structure 140 is positioned between the electrical contacts 130 and the semiconductor chips 150.

As shown in Fig. 11, the power semiconductor module 1 includes metal preforms 160 arranged on the contact surfaces of the plurality of semiconductor chips 150 facing the top plate 120. The multi-layered structure 140 may be positioned between the plurality of electrical contacts 130 and the plurality of metal preforms 160. In this embodiment, the multi-layered structure 140 may include through holes, allowing the electrical contacts 130 to extend through the multi-layered structure 140 and make direct contact with the metal preforms 160. Alternatively, the multi-layered structure 140 may feature recesses on one surface to accommodate and provide surface contact with the electrical contacts 130, while the opposite surface may have recesses for improved alignment with the metal preforms 160.Alternatively, the multi-layered structure 140 may comprise aligning structures on each or certain layers for improved arrangement with the electrical contacts 130 and/or metal preforms 160 and/or enhanced alignment between different electrically conducting elements 141.

According to the embodiment shown in Fig. 12, the multi-layered structure 140 may be in direct contact with the contact surfaces of the plurality of semiconductor chips 150. The electrical contacts 130 may be directly connected to the multi-layered structure 140. Alternatively, as illustrated in Fig. 12, the electrical contacts 130 may be connected to the multi-layered structure 140 via corresponding metal preforms 160. In other words, the pin foot 1312 of each electrical contact 130 may abut one of the metal preforms 160, with the multi-layered structure 140 positioned between the metal preforms 160 and the semiconductor chips 150.

Optionally, when the multi-layered structure 140 is arranged between the plurality of electrical contacts 130 and the plurality of semiconductor chips 150. Layers of the multi-layered structure 140 may be connected to each other via soldering, sintering or adhesive bonding to enhance mechanical stability.

Fig. 13 shows a flow chart according to an embodiment of a power semiconductor module assembling method. The method may be applied to assemble the power semiconductor modules 1 as described above. As shown in Fig. 13, the method comprises the following steps:
S101: attaching the plurality of semiconductor chips 150 to the electrically conducting base plate 110,
S102: interconnecting the plurality of electrical contacts 130 with the multi-layered structure 140,
S103: attaching the electrically conducting top plate 120 to the plurality of electrical contacts 130, and
S104: aligning and attaching the plurality of electrical contacts 130 to the plurality of semiconductor chips 150.

Specifically, the semiconductor chips can be attached to the base plate via soldering or sintering, adhesive bonding or other applicable approaches. It should be noted that a temporal sequence of the steps S103 and S104 may be changed. In some preferred embodiments, the top plate 120 may be attached or mounted to the electrical contacts 130 after connecting the plurality of electrical contacts 130 to the plurality of semiconductor devices 100.

Optionally, when the power semiconductor module 1 applies metal preforms for enhanced SCFM capability, the method may further comprise the following step between step S101 and S102:
S1011: attaching the plurality of metal preforms to the plurality of semiconductor chips 150.

The metal preforms 160 may be connected to the semiconductor chips 150 via soldering, sintering or adhesive bonding.

Optionally, when the multi-layered structure 140 is positioned between the plurality of electrical contacts 130 and the semiconductor chips 150 as shown in Fig. 12. **The** steps of interconnecting (S102) and attaching (S104) the plurality of electrical contacts 130 may further comprise the following steps respectively:
S1021: attaching the multi-layered structure 140 to the plurality of semiconductor chips 150 or the plurality of metal performs 160, and
S1041: aligning the plurality of electrical contacts 130 with the plurality of semiconductor chips 150 and connecting the plurality of electrical contacts 130 to the multi-layered structure 140.

When the electrical contacts are pressure contacts, the method may further comprise:
S105: pressing the top plate 120 towards a direction to the plurality of semiconductor chips 150.

Optionally, for pressure contacts, the method may further comprise the following step before attaching (S103) the top plate 120 to the plurality of electrical contacts 130:
S1031: arranging or sleeving a plurality of springs 1321 and/or electrically conducting brackets 1322 to a plurality of presspin bodies 131 of the electrical contacts 130.

Alternatively, when the top plate 120 may be attached or mounted to the electrical contacts 130 after connecting the plurality of electrical contacts 130 to the plurality of semiconductor devices 100, the method may also comprise: arranging or sleeving the plurality of springs 1321 and/or electrically conducting brackets 1322 to a plurality of presspin bodies 131 of the electrical contacts 130 before attaching or mounting the top plate 120 to the plurality of electrical contacts 130.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

1 power semiconductor module
110 electrically conducting base plate
120 electrically conducting top plate
130 electrical contact
131 presspin body
1312 pin foot
13121 stepped surface
132 elastic element
1321 spring
1322 electrically conducting bracket
140 multi-layered structure
141 electrically conducting element
141a-c electrically conducting element
1410 through hole or recess
1411 full plate
1412 partial plate
1413 full strip
1414 partial strip
1415 washer
150 semiconductor chip
160 metal preform

## Claims

1. A power semiconductor module (1) comprising:
an electrically conducting base plate (110) and an electrically conducting top plate (120) arranged parallel to each other,
a plurality of semiconductor chips (150) arranged on the baseplate (110) facing the top plate (120),
a plurality of electrical contacts (130), each arranged between the top plate (120) and one of the plurality of semiconductor chips (150), electrically connecting the plurality of semiconductor chips (150) in parallel, and
a multi-layered structure (140) comprising a stack of electrically conducting elements (141), wherein
the plurality of the electrical contacts (130) are interconnected by the multi-layered structure (140), and
each element (141) of the multi-layered structure (140) is mechanically and/or electrically connected to at least one of electrical contacts (130).

2. The power semiconductor module (1) according to the previous claim, where each layer of the multi-layered structure (140) comprises at least one electrically conducting elements (141).

3. The power semiconductor module (1) according to any one of the previous claims, wherein the electrically conducting elements (141) comprise:
a full plate (1411) interconnecting the plurality of electrical contacts (130),
a partial plate (1412) interconnecting a part of the plurality of electrical contacts (130),
a full strip (1413) interconnecting all of the plurality of electrical contacts (130) that arranged in a row or a column,
a partial strip (1414) interconnecting a subset of the plurality of electrical contacts (130) that arranged in a row or a column, and/or
a washer (1415) connected to one electrical contacts (130).

4. The power semiconductor module (1) according to any one of the previous claims, wherein
the electrically conducting elements (141) are made of a material with high electrical and thermal conductivities, and/or
the material comprises: copper, copper alloy, aluminium, and/or aluminium alloy.

5. The power semiconductor module (1) according to the previous claim, wherein
the electrically conducting elements (141) are provided with corresponding through holes and/or recesses (1410) for accommodating the plurality of electrical contacts (130).

6. The power semiconductor module (1) according to any one of the previous claims, wherein,
each of the electrically conducting element (141) has a thickness between 0.3 to 10mm, preferably 0.3 to 7 mm, most preferably 0.3 to 1.5 mm.

7. The power semiconductor module (1) according to any one of the previous claims, wherein
the plurality of electrical contacts (130), preferably each, comprises pressure contacts and/or columnar contacts.

8. The power semiconductor module (1) according to any one of the previous claims further comprising:
a plurality of metal preforms (160) each arranged between one of the plurality of electrical contacts (130) and the plurality of semiconductor chips (150).

9. The power semiconductor module (1) according to any one of the previous claims, wherein
each of the plurality of electrical contacts (130) comprises a presspin body (131) and an elastic element (132) arranged on the presspin body (131), and
each of the presspin body (131) comprises a pin foot (1312) towards the one of the plurality of semiconductor chip (150),
optionally, the elastic element (132) comprises a spring (1321) and/or an electrically conducting bracket (1322) surrounding the spring (1321).

10. The power semiconductor module (1) according to the previous claim, wherein
the multi-layered structure (140) is sleeved on the presspin bodies (131) between the elastic elements (132) and the pin feet (1312) of the presspin bodies (131).

11. The power semiconductor module (1) according to any of the previous two claims, wherein
the pin foot (1312) of each presspin body (131) has a diameter and/or width greater than an upper portion of the presspin body (131) and defines a stepped surface (13121) facing the top plate (120), and
the multi-layered structure (140) is sleeved on the upper portions of the presspin bodies (131) and is arranged between the elastic elements (132) and the stepped surfaces (13121).

12. The power semiconductor module (1) according to the previous three claims, wherein
the elastic element (132) comprises a spring (1321) and an electrically conducting bracket (1322) surrounding the spring (1321), and
the multi-layered structure (140) is sleeved on the presspin bodies (131) between the brackets (1322) and the pin feet (1312) of the presspin bodies (131).

13. The power semiconductor module (1) according to any one of the previous claims 1 to 9, wherein
the multi-layered structure (140) is arranged between the plurality of electrical contacts (130) and the plurality of semiconductor chips (150).

14. The power semiconductor module (1) according to the previous claim, wherein
each metal preform (160) is arranged on a contact surface of one of the plurality of semiconductor chips (150) facing the top plate (120), and
the multi-layered structure (140) is arranged between the plurality of electrical contacts (130) and the plurality of metal preforms (160), or
the pin foot (1312) of each electrical contacts (130) abuts one of the plurality of metal preforms (160), and
the multi-layered structure (140) is arranged between the plurality of metal preforms (160) and the plurality of semiconductor chips (150).

15. A method for assembling the power semiconductor module (1) according to any one of the previous claims, comprising the steps of:
attaching (S101) the plurality of semiconductor chips (150) to the electrically conducting base plate (110),
interconnecting (S102) the plurality of electrical contacts (130) with the multi-layered structure (140),
attaching (S103) the electrically conducting top plate (120) to the plurality of electrical contacts (130), and
aligning and attaching (S104) the plurality of electrical contacts (130) to the plurality of semiconductor chips (150).
